# EUROPEAN PATENT APPLICATION

(11) **EP 4 836 611 A1**
(43) Date of publication of application: **04.11.2026**
(21) Application number: 24909440.0
(22) Date of filing: 28.03.2024
(51) Int. Cl.: H05K 7/20, H02M 7/42

(54) **POWER CONVERSION APPARATUS**

(30) Priority: 30.12.2023 CN 202323669797 U
(71) Applicant: Sungrow Power Supply Co., Ltd., Hefei, Anhui 230088 (CN)
(72) Inventor: WANG, Wei, Hefei, Anhui 230088 (CN); YU, Renbin, Hefei, Anhui 230088 (CN); YANG, Ye, Hefei, Anhui 230088 (CN); ZHOU, Jie, Hefei, Anhui 230088 (CN); LIU, Long, Hefei, Anhui 230088 (CN); WANG, Peng, Hefei, Anhui 230088 (CN)
(74) Representative: Zacco Norway AS
(86) International application number: PCT/CN2024/084300
(87) International publication number: WO 2025/138471

(57) **Abstract**

Disclosed in the present application is a power conversion apparatus, comprising a first cavity, a second cavity and a heat dissipator, wherein a power device is provided in the first cavity; the heat dissipator comprises an evaporator and a condenser, which forms a circulating flow path with the evaporator, the evaporator being configured to absorb heat of the power device; the condenser is located in the second cavity, and the second cavity can allow air to flow through the condenser to cool the condenser; and a magnetic device is provided outside the second cavity. In the power conversion apparatus, the heat dissipator is used to perform heat dissipation on the power device, such that the heat dissipation capacity is effectively improved, and a heat dissipation requirement of the power conversion apparatus can be met; the magnetic device is externally arranged relative to the condenser, such that the second cavity has a relatively small size, thereby facilitating the mounting, disassembly and maintenance of the second cavity; a heat dissipation effect for the magnetic device can be improved; mutual interference between heat dissipation of the magnetic device and heat dissipation of the condenser can also be avoided; and the flexibility of structural layout of the power conversion apparatus can also be improved.

## Description

The present application claims priority to Chinese Patent Application No. 202323669797.8, titled "POWER CONVERSION APPARATUS", filed on December 30, 2023 with the China National Intellectual Property Administration, which is incorporated herein by reference in its entirety.

### FIELD

The present application relates to the technical field of heat dissipation of power electronic equipment, and in particular, to a power conversion apparatus.

### BACKGROUND

With the continuous increase in the power density of power conversion apparatus, such as inverters and power conversion systems (PCS), heat generation of such apparatus -particularly that of power devices within an enclosure-is growing significantly. Consequently, there is an increasingly high requirement for the heat dissipation capability of power conversion equipment.

Currently, power conversion apparatus primarily employs forced air cooling. However, the heat dissipation capacity of forced air cooling is difficult to be further improved, making it challenging to meet the heat dissipation requirements of the power conversion apparatus with ever-increasing power density.

In summary, how to design the heat dissipation of the power conversion apparatus to enhance the heat dissipation capacity and meet the heat dissipation requirements of the power conversion apparatus is an urgent issue that needs to be addressed by those skilled in the art.

### SUMMARY

In view of this, an object of the present application is to provide a power conversion apparatus to improve the heat dissipation capacity and meet the heat dissipation requirements of the power conversion apparatus.

In order to achieve the above object, the following technical solutions are provided according to the present application.

A power conversion apparatus includes: a first chamber, a second chamber, and a heat sink,
where a power device is disposed within the first chamber;
the heat sink includes an evaporator and a condenser connected to the evaporator to form a circulation flow path, and the evaporator is configured to absorb heat from the power device; and
the condenser is disposed within the second chamber, which is configured to allow air to flow through the condenser for cooling the condenser, and a magnetic device is disposed outside the second chamber.

Optionally, the evaporator is disposed within the second chamber.

Optionally, the second chamber includes a top chamber and a side chamber that are in communication with each other. The top chamber is located at a top of the first chamber, and the side chamber is located on a side of the first chamber. The evaporator is disposed within the side chamber, and the condenser is disposed within the top chamber.

Optionally, the evaporator is disposed within the first chamber.

Optionally, the evaporator is in contact with an inner wall of the first chamber. Alternatively, a gap is present between the evaporator and the inner wall of the first chamber.

Optionally, the power conversion apparatus further includes a first fan configured to drive air to flow through the condenser.

Optionally, the magnetic device is disposed outside the first chamber.

Optionally, the second chamber is provided with a second chamber air inlet and a second chamber air outlet.

The magnetic device faces the second chamber air inlet to enable the airflow to dissipate heat from the magnetic device before entering the second chamber air inlet. Alternatively, the magnetic device faces the second chamber air outlet to enable the airflow discharged from the second chamber air outlet to dissipate heat from the magnetic device.

Optionally, the power conversion apparatus further includes a third chamber, within which the magnetic device is disposed. The third chamber is configured to allow air to flow over the magnetic device for cooling the magnetic device.

Optionally, the power conversion apparatus further includes a second fan, which is configured to drive air to flow over the magnetic device.

Optionally, in a case that the power conversion apparatus further includes a first fan for driving air to flow through the condenser, the first fan is disposed outside the second chamber, and the second fan is disposed outside the third chamber.

The first fan and the second fan are the same fan. The third chamber and the second chamber share the fan assembly.

Optionally, the third chamber is arranged in parallel or in series with the second chamber.

Additionally/alternatively, there are at least two third chambers, which are respectively distributed on at least two sides of the second chamber.

Optionally, the magnetic device is disposed within the first chamber.

In the power conversion apparatus according to the present application, a heat sink is employed to dissipate heat form the power device. Compared with the air-cooling heat dissipation used in the related technologies, this design effectively improves the heat dissipation capacity, thereby meeting the heat dissipation requirements of the power conversion apparatus with high power density. Furthermore, the magnetic device is externally arranged relative to the condenser, so that the second chamber has a relatively small size, thereby facilitating the mounting, disassembly and maintenance of the second chamber. The magnetic device and the condenser are not located in the same chamber, so that the magnetic device may be cooled separately, thereby enhancing the heat dissipation effect of the magnetic device. Moreover, this arrangement prevents mutual interference between the heat dissipation of the magnetic device and the heat dissipation of the condenser, allowing both the condenser and the magnetic device to achieve superior heat dissipation effect. The magnetic device may be disregarded during the design and mounting of the condenser, and vice versa, the condenser may be disregarded during the design and mounting of the magnetic device, significantly enhancing the flexibility in the structural layout of the power conversion apparatus

### BRIEF DESCRIPTION OF THE DRAWINGS

In order to more clearly illustrate the technical solutions in the embodiments of the present application or in the related technologies, the accompanying drawings required for describing the embodiments or the related technologies will be briefly introduced below. It is apparent that the accompanying drawings described below only show some embodiments of the present application. Based on these accompanying drawings, other accompanying drawings may be obtained by those ordinary skilled in the art without any creative effort.
FIG. 1 is a structural schematic view of a power conversion apparatus according to a first embodiment of the present application;
FIG. 2 is another structural schematic view of the power conversion apparatus according to the first embodiment of the present application;
FIG. 3 is another structural schematic view of the power conversion apparatus according to the first embodiment of the present application;
FIG. 4 is another structural schematic view of the power conversion apparatus according to the first embodiment of the present application;
FIG. 5 is a structural schematic view of a power conversion apparatus according to a second embodiment of the present application;
FIG. 6 is another structural schematic view of the power conversion apparatus according to the second embodiment of the present application;
FIG. 7 is a side view of the power conversion apparatus shown in FIG. 6;
FIG. 8 is a top view of the power conversion apparatus shown in FIG. 6;
FIG. 9 is a structural schematic view of a power conversion apparatus according to a third embodiment of the present application; and
FIG. 10 is another structural schematic view of the power conversion apparatus according to the third embodiment of the present application;

Numeral references are listed as follows:
1. first chamber; 101. back plate; 2. second chamber; 201. second chamber air inlet; 202. second chamber air outlet; 203. top chamber; 204. side chamber; 3. condenser; 4. evaporator; 5. first fan; 6. power device; 7. magnetic device; 8. third chamber; 801. third chamber air inlet; 802. third chamber air outlet; 9. second fan; 10. fan.

### DETAILED DESCRIPTION OF THE EMBODIMENTS

Technical solutions in the embodiments of the present application are described clearly and completely below with reference to the accompanying drawings herein. It is apparent that the described embodiments are only some rather than all of the embodiments of the present application. Based on the embodiments of the present application, all other embodiments obtained by those skilled in the art without any creative work fall within the protection scope of the present application.

Technical solutions in the embodiments of the present application will be described clearly and completely below with reference to the accompany drawings herein. The terms in the following embodiments are used merely for the purpose of describing specific embodiments, and are not intended to limit the present application. As used in the specification and appended claims of the present application, the singular expressions such as "a", "one", "said", "the above", "the" and "this" are intended to include expressions such as "one or more", unless explicitly indicated otherwise in the context. It should also be understood that in the embodiments of the present application, the expression "one or more" refers to one, two or more. The expression "and/or" describes an association relationship between related objects and indicates there may be three types of relationships. For example, A and/or B may indicate three cases: A exists alone, A and B exist simultaneously, and B exists alone. In each case, the number of A may be one or more, and the number of B may be one or more. The character "/" generally indicates that an "or" relationship between the associated objects before and after the character "/".

In this specification, references to "one embodiment" or "some embodiments" and the like mean that a particular feature, structure, or characteristic described in conjunction with the embodiment is included in one or more embodiments of the present application. Thus, phrases such as "in one embodiment", "in some embodiments", "in other embodiments" and "in yet other embodiments" and the like appearing throughout this specification do not necessarily all refer to the same embodiment. Rather, they mean "one or more, but not all embodiments" unless otherwise specifically emphasized. The terms such as "comprising", "including", "having" and variations thereof mean "including, but not limited to" unless otherwise specifically emphasized.

The term "multiple or a plurality of" in the embodiments of the present application refers to two or more. It should be noted that in the description of the embodiments of the present application, words such as "first" and "second" are only used for the purpose of distinguishing descriptions, and should not be understood as indicating or implying relative importance or a specific order.

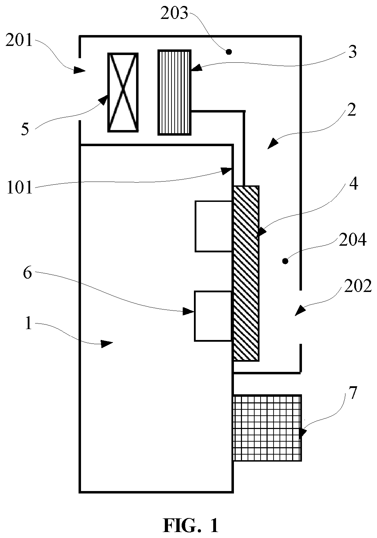

As shown in FIGS. 1 to 10, a power conversion apparatus provided according to an embodiment of the present application includes: a first chamber 1, a second chamber 2, and a heat sink (not shown in the figures).

A power device 6 is arranged in the first chamber 1. The power device 6 includes an insulate-gate bipolar transistor (IGBT) and the like, and the specific type and structure of the power device 6 are not limited in this embodiment.

In practical scenarios, other devices, such as resistors, capacitors, chips, etc., may also be arranged in the first chamber 1, and will not be limited in this embodiment. It should be noted that the resistor is a type of magnetic device.

The first chamber 1 may be a closed chamber or a high-protection chamber with relatively high protective performance.

The heat sink includes an evaporator 4 and a condenser 3 that forms a circulation flow path with the evaporator 4.

It should be noted that a circulation flow path is formed between the evaporator 4 and the condenser 3 through a gas phase pipeline and a liquid phase pipeline. The gas phase pipeline is configured to connect an outlet of the evaporator 4 to an inlet of the condenser 3, whereas the liquid phase pipeline is configured to connect an outlet of the condenser 3 to an inlet of the evaporator 4. A phase-change working medium can flow within the circulation flow path. To facilitate the circulation of the phase-change working medium, the condenser 3 and the evaporator 4 may be arranged at the same height, or the condenser 3 may be positioned higher than the evaporator 4.

The heat dissipation principle of the heat sink is as follows. The phase-change working medium inside the evaporator 4 absorbs heat and transforms from liquid phase to gas phase. The gas enters the condenser 3 through the gas phase pipeline, releases heat and condenses into liquid in the condenser 3. The liquid then flows back to the evaporator 4 through the liquid phase pipeline, completing the circulation.

The evaporator 4 is configured to absorb heat from the power device 6. Of course, the evaporator 4 may also absorb heat from other heat-generating devices in the first chamber 1, which is not limited in this embodiment.

The evaporator 4 is configured to be in direct contact with the power device 6. Alternatively, the evaporator 4 is configured to be in indirect contact with the power device 6 via a thermal conductive member.

The condenser 3 is disposed in the second chamber 2, and the second chamber 2 is configured to allow air to flow through the condenser 3 for cooling the condenser 3.

The condenser 3 may be a parallel-flow condenser or another type of condenser, which is not limited in this embodiment. Similarly, the type of the evaporator 4 is not limited in this embodiment.

The second chamber 2 has a second chamber air inlet 201 and a second chamber air outlet 202. The second chamber 2 may be in communication with an external environment of the entire power conversion apparatus or with other chambers inside the power conversion apparatus except the first chamber 1, as long as the cooling of the condenser 3 is ensured.

To enhance the cooling efficiency, the second chamber 2 may be configured as an open chamber, and the second chamber 2 is in communication with the external environment of the power conversion apparatus.

The relative positional relationship between the second chamber 2 and the first chamber 1 is determined based on actual conditions, which will not be limited in this embodiment.

In the power conversion apparatus, a heat sink is employed to dissipate heat form the power device 6. Compared with the air-cooling heat dissipation used in the related technologies, this design may effectively improve the heat dissipation capacity, and satisfy the heat dissipation requirements of the power conversion apparatus, especially those with high power density, thereby addressing the issue of insufficient heat dissipation capacity of traditional air-cooling heat dissipation as the power density increases.

In the power conversion apparatus, a magnetic device 7 is arranged outside the second chamber 2. The magnetic device 7 may include a reactor or other components, and the specific type of the magnetic device 7 is not limited in this embodiment.

It should be noted that, when a magnetic device such as a resistor is arranged in the first chamber 1, the type of the magnetic device 7 disposed outside the second chamber 2 is different from that of the magnetic device located in the first chamber 1.

In the power conversion apparatus, an external arrangement of the magnetic device 7 relative to the condenser 3 is achieved, so that the second chamber 2 has a relatively small size, thereby facilitating the mounting, disassembly and maintenance of the second chamber 2. The magnetic device 7 and the condenser 3 are not disposed within the same chamber, so that the magnetic device 7 may be cooled separately, thereby enhancing the heat dissipation effect of the magnetic device 7. Additionally, this may prevent mutual interference between the heat dissipation of the magnetic device 7 and the heat dissipation of the condenser 3, achieving better heat dissipation effect of both the condenser 3 and the magnetic device 7. Furthermore, the magnetic device 7 may be ignored during the design and mounting of the condenser 3, and similarly, the condenser 3 may be ignored during the design and mounting of the magnetic device 7, thereby enhancing the flexibility in the structural layout of the power conversion apparatus.

To facilitate airflow to flow through the condenser 3, the power conversion apparatus further includes a first fan 5, which is configured to drive air to flow through the condenser 3. The type, number, and distribution of the first fan 5 are determined based on actual conditions, which will not be limited in this embodiment.

It should be noted that the first fan 5 may be removed if the heat dissipation requirements of the condenser 3 are met.

In the power conversion apparatus, the arrangement of the evaporator 4 is determined based on actual situations.

In an aspect of the present application, as shown in FIGS. 1 to 8, the evaporator 4 may be disposed in the second chamber 2.

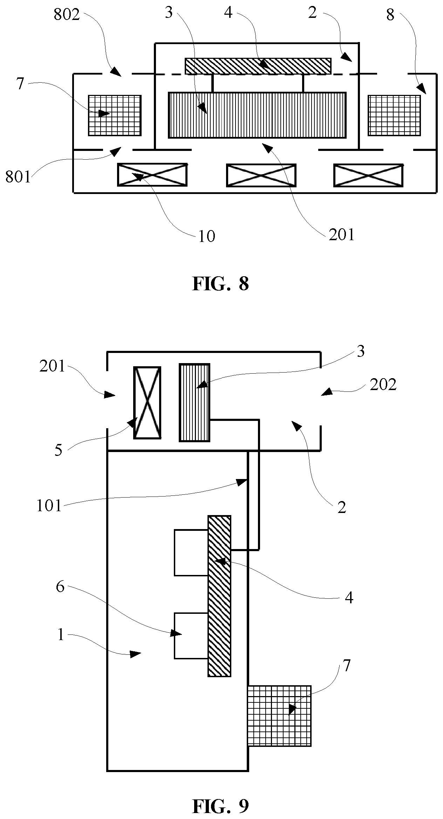

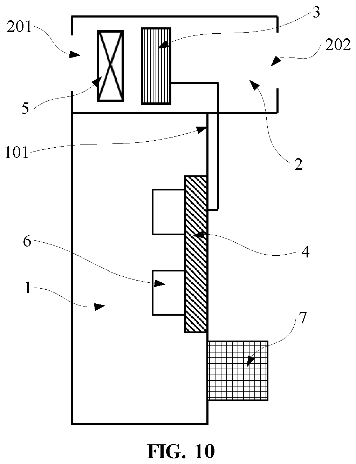

In another aspect of the present application, as shown in FIGS. 9 and 10, the evaporator 4 may be disposed in the first chamber 1. In this case, the evaporator 4 is externally arranged relative to the condenser 3, so that the hot air in the second chamber 2 is prevented from affecting the evaporator 4. As a result, the temperature of the evaporator 4 is relatively low, thereby enhancing the heat dissipation effect of the evaporator 4.

In the power conversion apparatus, the arrangement of the magnetic device 7 is determined based on actual situations. In some embodiments, the magnetic device 7 may be disposed outside the first chamber 1.

In the above structure, the air flowing through the condenser 3 may be directed towards the magnetic device 7. Specifically, the magnetic device 7 faces the second chamber air outlet 202 to enable the airflow discharged from the second chamber air outlet 202 to dissipate heat from the magnetic device 7. Alternatively, the air may flow over the magnetic device 7 before passing through the condenser 3. Specifically, the magnetic device 7 faces the second chamber air inlet 201 to enable the airflow to dissipate heat from the magnetic device 7 before entering the second chamber air inlet 201.

Since the magnetic device 7 has a higher temperature resistance than the condenser 3, the magnetic device 7 may face the second chamber air outlet 202.

In addition to the above heat dissipation modes, the magnetic device 7 may be cooled in other heat dissipation modes, which is not limited to the above heat dissipation modes.

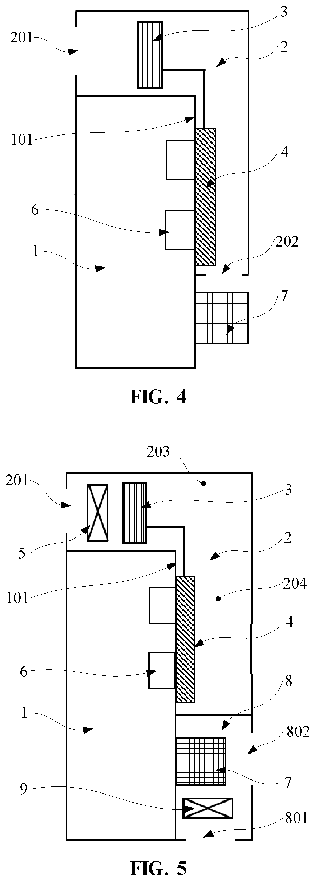

In a case that the magnetic device 7 is disposed outside both the first chamber 1 and the second chamber 2, the magnetic device 7 may be exposed, as shown in FIGS. 1 to 4 and FIG. 9. A third chamber 8 may be provided to accommodate the magnetic device 7, as shown in FIGS. 5 to 8.

In some other embodiments, as shown in FIGS. 5 to 8, the power conversion apparatus further includes a third chamber 8, and the magnetic device 7 is disposed in the third chamber 8. The third chamber 8 is configured to allow air to flow over the magnetic device 7 for cooling the magnetic device 7.

The third chamber 8 has a third chamber air inlet 801 and a third chamber air outlet 802. The third chamber 8 may be in communication with the external environment of the entire power conversion apparatus, or with another chamber inside the power conversion apparatus excluding the first chamber 1 and the second chamber 2, as long as the cooling of the magnetic device 7 may be ensured.

To improve the cooling efficiency, the third chamber 8 may be configured as an open chamber, and the third chamber 8 is in communication with the external environment of the power conversion apparatus.

To facilitate airflow over the magnetic device 7, the power conversion apparatus further includes a second fan 9, which is configured to drive air to flow over the magnetic device 7.

The type, number, and arrangement of the second fan 9 are determined based on actual conditions, which will not be limited in this embodiment.

It should be noted that the second fan 9 may be removed if the heat dissipation requirements of the condenser are met.

The flow of air in the third chamber 8 may be associated with the flow of air in the second chamber 2. For example, the third chamber 8 is in communication with the second chamber 2. Alternatively, the third chamber 8 and the second chamber 2 share a fan 10. Of course, the flow of air in the third chamber 8 may be independent from the flow of air in the second chamber 2, which will be determined based on actual conditions.

The relative positional relationship among the third chamber 8, the second chamber 2 and the first chamber 1 is determined based on actual conditions, which will not be limited in this embodiment.

In some other embodiments, the magnetic device 7 may be disposed in the first chamber 1.

It should be noted that the magnetic device 7 is disposed in the first chamber 1, representing a case where the magnetic device 7 is disposed outside the second chamber 2.

The arrangement of the evaporator 4 and the arrangement of the magnetic device 7 have been separately described above. In practical scenarios, the arrangement of the evaporator 4 and the arrangement of the magnetic device 7 may be combined. Specific details are provided below based on three embodiments.

### First Embodiment

As shown in FIGS. 1 to 4, in the power conversion apparatus according to a first embodiment, the evaporator 4 is disposed in the second chamber 2, whereas the magnetic device 7 is disposed outside both the first chamber 1 and the second chamber 2, and the magnetic device 7 is exposed outside both the first chamber 1 and the second chamber 2.

In the first embodiment, to facilitate the arrangement of the condenser 3 and the evaporator 4, the second chamber 2 may include a top chamber 203 and a side chamber 204 that are in communication with each other. The top chamber 203 is located at a top of the first chamber 1, and the side chamber 204 is located on a side of the first chamber 1. The evaporator 4 is located in the side chamber 204, and the condenser 3 is located in the top chamber 203. In this way, it is convenient to ensure that the condenser 3 is disposed higher than the evaporator 4, and it is also convenient for the evaporator 4 to dissipate heat from the power device 6.

The side chamber 204 may be located at a rear of the first chamber 1. For example, the side chamber 204 is disposed on an outer side of a back plate 101 of the first chamber 1.

In practical applications, the second chamber 2 may adopt other structures, which will not be limited to the above structure.

The second chamber air inlet 201 of the second chamber 2 may be provided in the top chamber 203, whereas the second chamber air outlet 202 of the second chamber 2 may be provided in the side chamber 204. Of course, it is possible to interchange the positions of the second chamber air inlet 201 and the second chamber air outlet 202, which will not be limited in the first embodiment.

In the first embodiment, there are two heat dissipation modes for the magnetic device 7. In one aspect, as shown in FIG. 1, the magnetic device 7 is exposed outside both the first chamber 1 and the second chamber 2, enabling the magnetic device 7 to be cooled by natural heat dissipation.

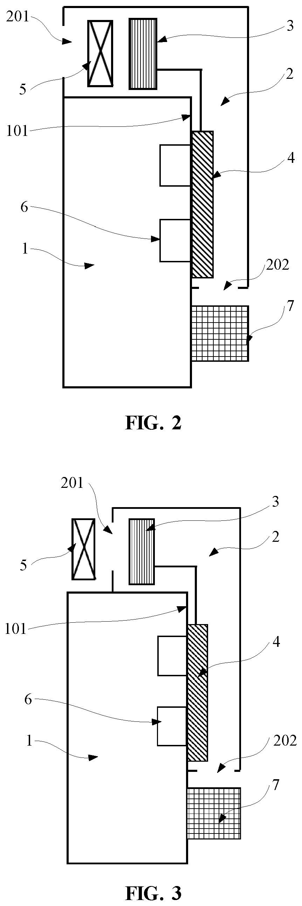

In another aspect of the present application, as shown in FIGS. 2 to 4, under the action of the first fan 5, the air flowing through the condenser 3 is directed towards the magnetic device 7. Specifically, the magnetic device 7 faces the second chamber air outlet 202 to allow the airflow discharged from the second chamber air outlet 202 to dissipate heat from the magnetic device 7.

Alternatively, the magnetic device 7 may face the second chamber air inlet 201 (as detailed above), and the heat dissipation mode is not limited to that shown in FIGS. 2 to 4.

It should be noted that the heat dissipation mode shown in FIGS. 2 to 4 creates an association between the heat dissipation of the condenser 3 and that of the magnetic device 7. During the actual mounting process, it is only necessary to ensure that the magnetic device 7 faces the second chamber air outlet 202 or the second chamber air inlet 201. Compared with the case where the magnetic device 7 is arranged in the second chamber 2, the design flexibility and mounting flexibility of the power conversion apparatus are improved to a certain extent.

In the first embodiment, as shown in FIGS. 1 to 3, a first fan 5 is arranged and is configured to drive airflow to flow through the condenser 3. Specifically, the first fan 5 is configured to drive the airflow to flow from the second chamber air inlet 201 to the second chamber air outlet 202. The first fan 5 is arranged at the second chamber air inlet 201. Alternatively, the first fan 5 may be arranged at the second chamber air outlet 202.

As shown in FIGS. 1 and 2, the first fan 5 is disposed within the second chamber 2. Alternatively, as shown in FIG. 3, the first fan 5 is disposed outside the second chamber 2.

In the structures shown in FIGS. 1 to 3, forced air-cooling is achieved for both the condenser 3 and the magnetic device 7, thereby improving the heat dissipation effect. Additionally, the condenser 3 and the magnetic device 7 share the first fan 5, thereby simplifying the structure and reducing the cost.

As shown in FIG. 4, it is also possible to allow air to flow through the condenser 3 naturally, meaning that the first fan 5 is removed.

In the first embodiment, for other structures of the power conversion apparatus, reference may be made to the preceding descriptions, which will not be described in detail herein.

### Second Embodiment

As shown in FIGS. 5 to 8, a difference between the power conversion apparatus provided in a second embodiment and that in the first embodiment primarily lies in the fact that the magnetic device 7 is arranged in the third chamber 8.

It should be noted that, in the second embodiment, the evaporator 4 is disposed in the second chamber 2.

In the second embodiment, as shown in FIG. 5, the third chamber 8 may be disposed on the side of the first chamber 1. For example, the third chamber 8 is disposed on the back plate 101 of the first chamber 1.

In a case that the second chamber 2 includes a top chamber 203 and a side chamber 204, the third chamber 8 may be located at a bottom of the side chamber 204.

The third chamber 8 has a third chamber air inlet 801 and a third chamber air outlet 802, allowing air to flow over the magnetic device 7 in order to cool the magnetic device 7. The positions of the third chamber air inlet 801 and the third chamber air outlet 802 may be determined based on actual conditions.

In a case where the third chamber 8 is located at the bottom of the side chamber 204, with the second chamber air inlet 201 located in the top chamber 203 and the second chamber air outlet 202 located in the side chamber 204, the third chamber air inlet 801 may be located at a bottom of the third chamber 8, and the third chamber air outlet 802 may be located at a top on one side of the third chamber 8. This arrangement prevents mutual interference between the air intake and exhaust of the second chamber 2 and those of the third chamber 8.

It should be noted that the second chamber air outlet 202 is not shown in FIG. 5.

In actual situations, the third chamber air inlet 801 and the third chamber air outlet 802 may be provided at other locations, which will not be limited in the second embodiment.

In the second embodiment, the second fan 9 may be provided or removed, depending on the heat dissipation requirements of the magnetic device 7.

In a case that the second fan 9 is provided, it may be disposed inside or outside the third chamber 8. Specifically, the second fan 9 is disposed at the third chamber air inlet 801 or the third chamber air outlet 802.

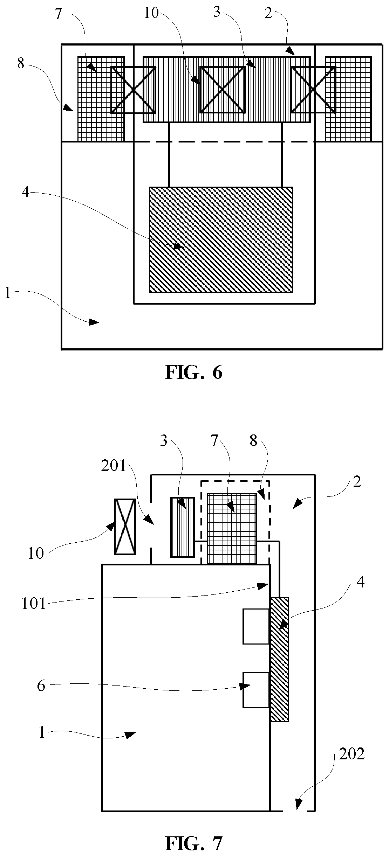

In the second embodiment, as shown in FIGS. 6 to 8, the third chamber 8 is located at the top of the first chamber 1. In actual situations, the third chamber 8 may be disposed at other positions, which will not be limited in the second embodiment.

Since both the second chamber 2 and the third chamber 8 require airflow to flow through, a fan 10 may be shared by the third chamber 8 and the second chamber 2. In this case, the fan 10 is disposed outside both the second chamber 2 and the third chamber 8. The first fan 5 and the second fan 9 mentioned above may be both called as the fan 10, meaning that the first fan 5 and the second fan 9 mentioned above are actually the same fan.

There may be one or more fans 10, depending on actual situations.

In the second embodiment, by sharing the fan 10 between the third chamber 8 and the second chamber 2, the number of fans 10 may be reduced, thereby simplifying the structure of the power conversion apparatus and lowering the cost of the power conversion apparatus.

In a case where the fan 10 is shared by the third chamber 8 and the second chamber 2, the third chamber 8 may be arranged in parallel or in series with the second chamber 2.

In a case where the third chamber 8 is arranged in parallel with the second chamber 2, the third chamber air inlet 801 and the second chamber air inlet 201 may be located on the same side. For example, the fan 10 is disposed at both the third chamber air inlet 801 and the second chamber air inlet 201. In this way, the air flowing through the fan 10 is divided into two portions: one portion flows through the second chamber 2, and the other portion flows through the third chamber 8.

To facilitate arranging the third chamber air inlet 801 and the second chamber air inlet 201 on the same side, in a case that the second chamber 2 includes a top chamber 203 and a side chamber 204, with the second chamber air inlet 201 located in the top chamber 203, the third chamber 8 is disposed at the top of the first chamber 1, meaning that the third chamber 8 is arranged in parallel with the top chamber 203.

Alternatively, the third chamber 8 may be disposed at other positions, which will not be limited in the second embodiment.

In a case that the third chamber 8 is arranged in series with the second chamber 2, the third chamber 8 is located downstream or upstream of the second chamber 2. To improve the cooling efficiency of the condenser 3, the third chamber 8 may be located downstream of the second chamber 2.

In a case that the second chamber 2 includes a top chamber 203 and a side chamber 204, with the second chamber air inlet 201 located in the top chamber 203 and the second chamber air outlet 202 located in the side chamber 204, if the third chamber 8 is located downstream of the second chamber 2, the third chamber 8 may be located on the side of the first chamber 1, and the third chamber 8 is located on one side or at the bottom of the side chamber 204. Alternatively, if the third chamber 8 is located upstream of the second chamber 2, the third chamber 8 may be located at the top of the first chamber 1, and the third chamber 8 is located on one side of the top chamber 203.

Alternatively, the third chamber 8 may be disposed at other positions, which will not be limited in the second embodiment.

In the second embodiment, there may be one or more third chambers 8. In a case that there are two or more third chambers 8, to improve the heat dissipation effect of the magnetic device 7, the third chambers 8 may be arranged in parallel with the second chambers 2, meaning that every two third chambers 8 are also arranged in parallel with each other.

In a case that there are two or more third chambers 8, the third chambers 8 may be arranged in series with the second chambers 2, meaning that every two third chambers 8 are also arranged in series with each other.

In a case that there are two or more third chambers 8, at least one of the third chambers 8 may be arranged in parallel with the second chamber 2, whereas at least another one third chamber 8 may be arranged in series with the second chamber 2.

In a case that there are two or more third chambers 8 and they are arranged in parallel with the second chamber 2, all the third chambers 8 may be distributed on at least two sides of the second chamber 2, facilitating the parallel arrangement of the third chambers 8 and the second chamber 2. Alternatively, all the third chambers 8 may be distributed on only one side of the second chamber 2.

In a case that there are two or more third chambers 8 and they are arranged in series with the second chamber 2, all the third chambers 8 may be distributed on only one side of the second chamber 2, facilitating the series arrangement of the third chambers 8 and the second chamber 2. Alternatively, all the third chambers 8 may be respectively distributed on at least two sides of the second chamber 2.

It should be noted that in a case that all the third chambers 8 are respectively distributed on at least two sides of the second chamber 2, all the third chambers 8 may be evenly or unevenly distributed on both sides of the second chamber 2, or all the third chambers 8 may be respectively distributed on three sides of the second chamber 2.

In the second embodiment, for other structures of the power conversion apparatus, reference may be made to the preceding descriptions, which will not be described in detail herein.

### Third Embodiment

As shown in FIGS. 9 and 10, a difference between the power conversion apparatus provided in the third embodiment and that in the first embodiment primarily lies in the fact that the evaporator 4 is disposed in the first chamber 1.

As shown in FIG. 9, the evaporator 4 is in contact with an inner wall of the first chamber 1. Alternatively, as shown in FIG. 10, a gap is present between the evaporator 4 and the inner wall of the first chamber 1.

In the case where a gap is present between the evaporator 4 and the inner wall of the first chamber 1, an electronic device may or may not be arranged in the gap, which will not be limited in this embodiment.

In the third embodiment, the magnetic device 7 is disposed outside both the first chamber 1 and the second chamber 2, and the magnetic device 7 may be cooled by natural heat dissipation. In this case, the second chamber 2 may be disposed on the top of the first chamber 1.

The magnetic device 7 may be arranged at the second chamber air inlet 201, such that the airflow passes over the magnetic device 7 before flowing through the condenser 3. Alternatively, the magnetic device 7 may be arranged at the second chamber air outlet 202, such that the airflow passes over the magnetic device 7 after flowing through the condenser 3.

In the third embodiment, the magnetic device 7 may be arranged in the third chamber. For the arrangement of the magnetic device 7 and the third chamber, reference may be made to the preceding descriptions, which will not be described in detail herein.

In the third embodiment, for other structures of the power conversion apparatus, reference may be made to the preceding descriptions, which will not be described in detail herein.

In the power conversion apparatus provided according to the embodiments of the present application, the combinations of the arrangement of the evaporator 4 and the arrangement of the magnetic device 7 are not limited to the three embodiments described above. Other combinations may be selected depending on actual conditions, which will not be limited in the embodiments of the present application.

The power conversion apparatus provided in the embodiments of the present application may be an inverter, a power conversion system or other types, which will not be limited in the embodiments of the present application.

The above description of the disclosed embodiments enables those skilled in the art to implement or utilize the present application. It is apparent for those skilled in the art to make various modifications to these embodiments. The general principle defined herein may be applied to other embodiments without departing from the spirit or scope of the present application. Hence, the present application is not limited to the embodiments described herein but conforms to a widest scope in accordance with the principle and novel features disclosed herein.

## Claims

1. A power conversion apparatus, comprising: a first chamber, a second chamber, and a heat sink;
wherein a power device is disposed within the first chamber;
the heat sink comprises an evaporator and a condenser connected to the evaporator to form a circulation flow path, and the evaporator is configured to absorb heat from the power device; and
the condenser is disposed within the second chamber, which is configured to allow air to flow through the condenser for cooling the condenser; and a magnetic device is disposed outside the second chamber.

2. The power conversion apparatus according to claim 1, wherein the evaporator is disposed within the second chamber.

3. The power conversion apparatus according to claim 2, wherein the second chamber comprises a top chamber and a side chamber that are in communication with each other, wherein the top chamber is located at a top of the first chamber, the side chamber is located on a side of the first chamber, the evaporator is disposed within the side chamber, and the condenser is disposed within the top chamber.

4. The power conversion apparatus according to claim 1, wherein the evaporator is disposed within the first chamber.

5. The power conversion apparatus according to claim 4, wherein the evaporator is in contact with an inner wall of the first chamber; or
a gap is present between the evaporator and the inner wall of the first chamber.

6. The power conversion apparatus according to claim 1, further comprising a first fan configured to drive air to flow through the condenser.

7. The power conversion apparatus according to any one of claims 1 to 6, wherein the magnetic device is disposed outside the first chamber.

8. The power conversion apparatus according to claim 7, wherein
the second chamber is provided with a second chamber air inlet and a second chamber air outlet; wherein
the magnetic device faces the second chamber air inlet to enable airflow to dissipate heat from the magnetic device before entering the second chamber air inlet; or
the magnetic device faces the second chamber air outlet to enable the airflow discharged from the second chamber air outlet to dissipate heat from the magnetic device.

9. The power conversion apparatus according to any one of claims 1 to 6, further comprising a third chamber, wherein the magnetic device is disposed within the third chamber, which is configured to allow air to flow over the magnetic device for cooling the magnetic device.

10. The power conversion apparatus according to claim 9, further comprising a second fan configured to drive air to flow over the magnetic device.

11. The power conversion apparatus according to claim 10, wherein in a case that the power conversion apparatus further comprises a first fan configured for driving air to flow through the condenser, wherein the first fan is disposed outside the second chamber, and the second fan is disposed outside the third chamber; and
wherein the first fan and the second fan are the same fan, the third chamber and the second chamber share the fan assembly.

12. The power conversion apparatus according to claim 11, wherein the third chamber is arranged in parallel or in series with the second chamber;
and/or, there are at least two third chambers, which are respectively distributed on at least two sides of the second chamber.

13. The power conversion apparatus according to any one of claims 1 to 6, wherein the magnetic device is disposed within the first chamber.
